# EUROPEAN PATENT APPLICATION

(11) **EP 4 734 675 A1**
(43) Date of publication of application: **29.04.2026**
(21) Application number: 24853146.9
(22) Date of filing: 27.02.2024
(51) Int. Cl.: H05K 5/02

(54) **HOUSING AND ELECTRONIC DEVICE**

(30) Priority: 15.08.2023 CN 202311025571
(71) Applicant: Honor Device Co., Ltd., Shenzhen, Guangdong 518040 (CN)
(72) Inventor: ZHAO, Zhe, Shenzhen, Guangdong 518040 (CN); WANG, Chenyu, Shenzhen, Guangdong 518040 (CN); WANG, Ya, Shenzhen, Guangdong 518040 (CN); LIU, Yang, Shenzhen, Guangdong 518040 (CN); YANG, Hongde, Shenzhen, Guangdong 518040 (CN)
(74) Representative: Goddar, Heinz J.
(86) International application number: PCT/CN2024/078794
(87) International publication number: WO 2025/035730

(57) **Abstract**

This application provides a housing and an electronic device. The housing includes a frame body and an overmolded part. A first mounting frame of the frame body is provided with a first mounting groove, and a first sidewall of the first mounting groove is provided with a retention groove. A first convex rib of the first mounting frame is fixedly connected to the first sidewall, a side surface of the first convex rib is recessed inwardly toward the first convex rib, and a first limiting groove is formed between the side surface of the first convex rib and the first sidewall. A second mounting frame of the overmolded part includes a second sidewall, the second sidewall is provided with a first groove, and a sidewall of the first groove is provided with a first engagement part. A protrusion of the overmolded part is fixedly connected to the second sidewall. The overmolded part is formed on the frame body, the first convex rib is located in the first groove, the first engagement part is located in the first limiting groove, and is engaged with the first limiting groove in a direction perpendicular to the first sidewall, and the protrusion is located in the retention groove, and is engaged with the retention groove in a width direction of the first sidewall. The housing provided in this application may be used to resolve a technical problem in the conventional technology that the overmolded part of the housing of the electronic device is prone to be separated from the frame body.

## Description

This application claims priority to Chinese Patent Application No. 202311025571.6, entitled "HOUSING AND ELECTRONIC DEVICE" filed with the China National Intellectual Property Administration on August 15, 2023, which is incorporated herein by reference in its entirety.

### TECHNICAL FIELD

This application relates to the technical field of electronic devices, and in particular, to a housing and an electronic device.

### BACKGROUND

With development of science and technologies, an appearance (ID) form of an electronic device (for example, a mobile phone or a tablet computer) tends to develop from a bar-type device to a foldable device. The foldable device has a large-area screen in an unfolded state and therefore fully meets visual experience of a consumer; and has a small volume in a folded state and therefore is easy to carry. Use of a plastic middle frame facilitates weight reduction and corrosion protection of the electronic device. However, in the conventional technology, a connection between a metal part and a plastic part of the plastic middle frame is not stable, and separation is prone to occur in a shaft region.

### SUMMARY

This application provides a housing and an electronic device, to resolve a technical problem in the conventional technology that an overmolded part of the housing of the electronic device is prone to be separated from a frame body.

This application provides a housing, including a frame body and an overmolded part. The frame body includes a first mounting frame, the first mounting frame is provided with a first mounting groove, the first mounting groove includes a first sidewall, the first sidewall is provided with a retention groove, the first mounting frame includes a first convex rib, the first convex rib is fixedly connected to the first sidewall, a side surface of the first convex rib is recessed inwardly toward the first convex rib, and a first limiting groove is formed between the side surface of the first convex rib and the first sidewall. The overmolded part includes a second mounting frame, the second mounting frame includes a second sidewall, the second sidewall is provided with a first groove, a sidewall of the first groove is provided with a first engagement part, the overmolded part further includes a protrusion, and the protrusion is fixedly connected to the second sidewall.

The overmolded part is formed on the frame body, the second mounting frame is located in the first mounting groove, the second sidewall is opposite to the first sidewall, the first convex rib is located in the first groove, the first engagement part is located in the first limiting groove, and is engaged with the first limiting groove in a direction perpendicular to the first sidewall, and the protrusion is located in the retention groove, and is engaged with the retention groove in a width direction of the first sidewall.

In this embodiment, the housing includes a middle frame and a rear cover. The rear cover is fixedly connected to the middle frame. In another embodiment, the middle frame and the rear cover may be an integral part. The middle frame includes the frame body and the overmolded part. The first mounting frame and the second mounting frame are configured to mount a rotating shaft of the electronic device. That is, the first mounting frame and the second mounting frame are located in a shaft region of the middle frame. In this embodiment, the overmolded part covers an outer surface of the frame body, so that the frame body can be protected, and the middle frame can be prevented from being corroded by salt spray or the like, thereby improving corrosion resistance of the middle frame. Therefore, the electronic device can be used stably in a corrosion environment without failure, to improve durability of the electronic device. In addition, a mass of the middle frame can be reduced, to help implement a lightweight design of the electronic device, thereby improving user experience.

In this embodiment, the first limiting groove is disposed on the first mounting frame. Therefore, when the overmolded part is formed on the frame body, the first engagement part is formed in the first limiting groove, and the first engagement part is engaged with the first limiting groove, so that the first limiting groove plays a limiting role on the first engagement part. In this way, the overmolded part can be prevented from being separated from the frame body when a force is exerted on the overmolded part in the direction perpendicular to the first sidewall. In addition, the retention groove is disposed on the first mounting frame. Therefore, when the overmolded part is formed on the frame body, the protrusion is formed in the retention groove, and the protrusion is engaged with the retention groove, so that the retention groove plays a limiting role on the protrusion. In this way, the overmolded part can be prevented from being separated from the frame body when a force is exerted on the overmolded part in the width direction of the first sidewall, thereby improving stability of a connection between the overmolded part and the frame body, preventing the overmolded part from being separated from the frame body in the shaft region, and implementing a retention effect between the frame body and the overmolded part.

In an implementation, the side surface of the first convex rib is an inclined surface. When a force is exerted on the overmolded part in the direction perpendicular to the first sidewall, the overmolded part abuts against the inclined surface, and the inclined surface plays a limiting role on the overmolded part, so that the overmolded part can be prevented from being separated from the frame body.

In another implementation, the side surface of the first convex rib is a curved surface. When a force is exerted on the overmolded part in the direction perpendicular to the first sidewall, the overmolded part abuts against the curved surface, and the inclined surface plays a limiting role on the overmolded part, so that the overmolded part can be prevented from being separated from the frame body.

In a possible implementation, the side surface of the first convex rib includes a first side surface and a second side surface, the first side surface and the second side surface are opposite to each other, and the first side surface and the second side surface are respectively located on two opposite sides of the first convex rib in a length direction of the frame body. The first limiting groove includes a first sub-limiting groove and a second sub-limiting groove, the first sub-limiting groove is formed between the first side surface and the first sidewall, and the second sub-limiting groove is formed between the second side surface and the first sidewall. The first engagement part includes a first sub-engagement part and a second sub-engagement part, and the first sub-engagement part and the second sub-engagement part are respectively disposed on two opposite sidewalls of the first groove in a length direction of the overmolded part.

The overmolded part is formed on the frame body, the first sub-engagement part is located in the first sub-limiting groove, and is engaged with the first sub-limiting groove in the direction perpendicular to the first sidewall, and the second sub-engagement part is located in the second sub-limiting groove, and is engaged with the second sub-limiting groove in the direction perpendicular to the first sidewall.

In this embodiment, the first sub-limiting groove and the second sub-limiting groove are disposed on two opposite sides of the first convex rib, and the first sub-engagement part and the second sub-engagement part are respectively formed on two opposite sidewalls of the first groove correspondingly, so that the first sub-limiting groove plays a limiting role on the first sub-engagement part, and the second sub-limiting groove plays a limiting role on the second sub-engagement part. In this way, the overmolded part can be further prevented from being separated from the frame body when a force is exerted on the overmolded part in the direction perpendicular to the first sidewall, thereby further improving stability of a connection between the overmolded part and the frame body.

In a possible implementation, there are a plurality of first convex ribs, the plurality of first convex ribs are disposed at intervals in a length direction of the first sidewall, the first limiting groove is formed between a side surface of each first convex rib and the first sidewall, there are a plurality of first grooves, the plurality of first grooves are disposed in a one-to-one correspondence with the plurality of first convex ribs, and a sidewall of each first groove is provided with the first engagement part.

One first convex rib is formed in one first groove, and one first engagement part is formed in one first limiting groove. In this embodiment, a plurality of first convex ribs are disposed in the length direction of the first sidewall, and a plurality of first limiting grooves are formed, so that one first engagement part is formed in each first limiting groove. Therefore, each first limiting groove plays a limiting role on a corresponding first engagement part when a force is exerted on the overmolded part in the direction perpendicular to the first sidewall, so that the overmolded part can be further prevented from being separated from the frame body, thereby improving stability of a connection between the overmolded part and the frame body.

In a possible implementation, there are a plurality of retention grooves, the retention grooves are recessed on the first sidewall, the plurality of retention grooves are disposed at intervals in the length direction of the first sidewall, there are a plurality of protrusions, the plurality of protrusions are disposed in a one-to-one correspondence with the plurality of retention grooves, one protrusion is formed in one retention groove, and the protrusion is engaged with the corresponding retention groove in the width direction of the first sidewall.

In this embodiment, a plurality of retention grooves are disposed on the first sidewall in the length direction of the first sidewall, and a plurality of protrusions are disposed on the second sidewall in the length direction of the first sidewall. Therefore, the frame body plays a limiting role on the overmolded part at a plurality of positions in the length direction of the first sidewall, so that the overmolded part can be further prevented from being separated from the overmolded part in the width direction of the first sidewall, thereby further improving stability of a connection between the overmolded part and the frame body.

In a possible implementation, the first mounting frame further includes a second convex rib, the second convex rib is disposed side by side with and spaced apart from the first convex rib in the width direction of the first sidewall, a side surface of the second convex rib is recessed in a direction of the second convex rib, and a second limiting groove is formed between the side surface of the second convex rib and the first sidewall. The second sidewall is further provided with a second groove, and a sidewall of the second groove is provided with a second engagement part. The overmolded part is formed on the frame body, the second convex rib is located in the second groove, and the second engagement part is located in the second limiting groove, and is engaged with the second limiting groove in the direction perpendicular to the first sidewall.

In this embodiment, the second convex rib is disposed, and the second limiting groove is formed, so that the second engagement part is formed in the second limiting groove when the overmolded part is formed on the frame body. Therefore, when a force is exerted on the overmolded part in the direction perpendicular to the first sidewall, the first engagement part abuts against a groove wall of the second limiting groove, and the second limiting groove plays a limiting role on the second engagement part, so that the overmolded part can be further prevented from being separated from the frame body in the direction perpendicular to the first sidewall, thereby improving stability of connection between the overmolded part and the frame body.

In a possible implementation, the retention groove is located between the first convex rib and the second convex rib that are adjacent to each other.

In this embodiment, the retention groove is disposed between the first convex rib and the second convex rib, and is recessed on the first sidewall, so that both an abutting wall of the retention groove and side surfaces that are of the first convex rib and the second convex rib and that face the retention groove can play a limiting role on the protrusion. In this way, the overmolded part can be further prevented from being separated from the frame body when a force is exerted on the overmolded part in the width direction of the first sidewall, thereby further improving stability of a connection between the overmolded part and the frame body.

In a possible implementation, the retention groove is located between the first convex rib and the second convex rib, and a bottom wall of the retention groove is flush with the first sidewall.

In this embodiment, the retention groove is disposed between the first convex rib and the second convex rib, and the bottom wall of the retention groove is flush with the first sidewall. Therefore, it can be ensured that when the overmolded part is prevented from being separated in the width direction of the first sidewall, a structure of the frame body is simplified, and a manufacturing process of the frame body is reduced.

In a possible implementation, the frame body further includes a middle plate, the middle plate is disposed side by side with the first mounting frame, and is fixedly connected to one side of the first mounting frame, the overmolded part further includes a border frame, the border frame is fixedly connected to the second mounting frame, and the border frame covers an outer edge of the middle plate.

In this embodiment, the border frame covers the outer edge of the middle plate, so that the outer edge of the middle plate can be protected, thereby improving corrosion resistance of the middle frame, and improving durability of the electronic device.

In a possible implementation, the first sidewall is further provided with an engagement groove, the second mounting frame is further provided with an engagement protrusion, the engagement protrusion is fixedly connected to the second sidewall, and the engagement protrusion is formed in the engagement groove, and is engaged with the engagement groove.

In this embodiment, the engagement groove is disposed on the first sidewall, the engagement protrusion is correspondingly disposed on the second mounting frame, and the engagement protrusion is formed in the engagement groove, thereby further improving stability of a connection between the overmolded part and the frame body.

In a possible implementation, a material of the frame body is metal, and a material of the overmolded part is plastic.

The middle frame in this embodiment includes the frame body of the metal material and the overmolded part of the plastic material. Compared with a middle frame of pure metal, the middle frame in this embodiment has a lighter mass, so that a weight can be reduced, thereby helping implement a lightweight design of the electronic device, and improve user experience.

This application further provides an electronic device, including a rear cover, a display screen, and the foregoing housing, where both the rear cover and the display screen are mounted on the housing.

The electronic device provided in this embodiment is lightweight and has excellent corrosion resistance. In addition, the housing of the electronic device provided in this embodiment has good stability and is not prone to a case in which the overmolded part is separated.

In a possible implementation, the second mounting frame includes an accommodation groove, there are two housings, the two housings are disposed side by side, and accommodation grooves of the two housings are opposite to each other and communicate with each other. The electronic device further includes a rotating shaft, the rotating shaft is mounted in the accommodation groove, and is fixedly connected to the two housings, and rotation of the rotating shaft is capable of driving the two housings to rotate relative to each other.

In this embodiment, a region in which the first mounting frame and the second mounting frame are located is a mounting region of the rotating shaft, namely, a shaft region of the electronic device. The housing of the electronic device in this embodiment has excellent structural stability in the shaft region, and is not prone to a case in which the overmolded part is separated.

In conclusion, in this application, the first limiting groove is disposed on the first mounting frame. Therefore, when the overmolded part is formed on the frame body, the first engagement part is formed in the first limiting groove, and the first engagement part is engaged with the first limiting groove, so that the first limiting groove plays a limiting role on the first engagement part. In this way, the overmolded part can be prevented from being separated from the frame body when a force is exerted on the overmolded part in the direction perpendicular to the first sidewall. In addition, the retention groove is disposed on the first mounting frame. Therefore, when the overmolded part is formed on the frame body, the protrusion is formed in the retention groove, and the protrusion is engaged with the retention groove, so that the retention groove plays a limiting role on the protrusion. In this way, the overmolded part can be prevented from being separated from the frame body when a force is exerted on the overmolded part in the width direction of the first sidewall, thereby improving stability of a connection between the overmolded part and the frame body, preventing the overmolded part from being separated from the frame body in the shaft region, and implementing a retention effect between the frame body and the overmolded part.

### BRIEF DESCRIPTION OF DRAWINGS

To describe technical solutions in embodiments or the background of this application more clearly, the following describes accompanying drawings required in the embodiments or the background of this application.
FIG. 1 is a schematic diagram of a structure of an electronic device in a folded state according to an embodiment of this application;
FIG. 2 is a schematic diagram of a structure of the electronic device shown in FIG. 1 in an unfolded state;
FIG. 3 is a schematic diagram of a structure of a middle frame in the electronic device shown in FIG. 2;
FIG. 4 is a schematic diagram of a structure of a first middle frame in the middle frame shown in FIG. 3;
FIG. 5 is a schematic diagram of an exploded structure of the first middle frame shown in FIG. 4;
FIG. 6 is a schematic diagram of a structure of a frame body in the first middle frame in FIG. 4;
FIG. 7 is an enlarged schematic diagram of a structure of a region A of the frame body shown in FIG. 6;
FIG. 8 is a schematic diagram of a structure of an overmolded part in the first middle frame shown in FIG. 5;
FIG. 9 is an enlarged schematic diagram of a structure of a region B of the overmolded part shown in FIG. 8.
FIG. 10 is a schematic diagram of a partial cross-sectional structure of the first middle frame shown in FIG. 4 in a C-C direction; and
FIG. 11 is a flowchart of manufacturing the first middle frame shown in FIG. 4.

### DESCRIPTION OF EMBODIMENTS

The following describes embodiments of this application with reference to accompanying drawings in the embodiments of this application.

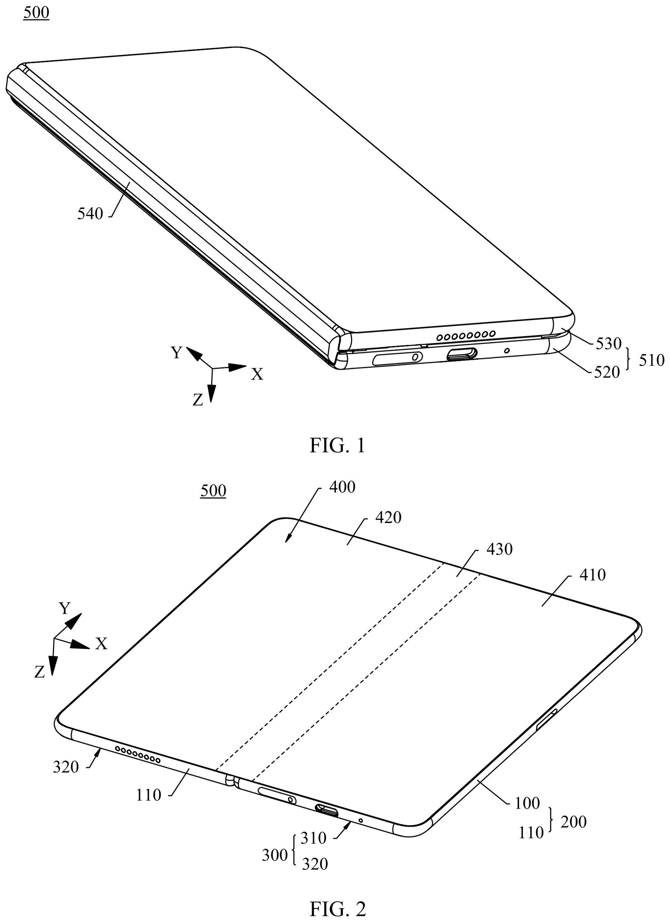

Refer to FIG. 1 and FIG. 2. FIG. 1 is a schematic diagram of a structure of an electronic device 500 in a folded state according to an embodiment of this application, and FIG. 2 is a schematic diagram of a structure of the electronic device 500 shown in FIG. 1 in an unfolded state.

For ease of description, a width direction of the electronic device 500 is defined as a direction X, a length direction of the electronic device 500 is defined as a direction Y, and a thickness direction of the electronic device 500 is defined as a direction Z. The X direction, the Y direction, and the Z direction are perpendicular to each other.

The electronic device 500 includes but is not limited to a mobile phone (cellphone), a notebook computer (notebook computer), a tablet computer (tablet personal computer), a laptop computer (laptop computer), a personal digital assistant (personal digital assistant), a wearable device (wearable device), a vehicle-mounted device (mobile device), or the like. In the embodiments of this application, an example in which the electronic device 500 is a mobile phone is used for description.

The electronic device 500 includes a housing 510, a display screen 400, and a rotating shaft 540. In this embodiment, the housing 510 includes a middle frame 200 and a rear cover 300. The rear cover 300 is fixedly connected to the middle frame 200. The housing 510 includes a first housing 520 and a second housing 530. The first housing 520 and the second housing 530 are disposed side by side. The middle frame 200 includes a first middle frame 100 and a second middle frame 110. The rear cover 300 includes a first rear cover 310 and a second rear cover 320. The first rear cover 310 is mounted on the first middle frame 100, and the first rear cover and the first middle frame jointly constitute the first housing 520. The second rear cover 320 is mounted on the second middle frame 110, and the second rear cover and the second middle frame jointly constitute the second housing 530. In another embodiment, the middle frame 200 and the rear cover 300 may be an integral part. That is, the first rear cover 310 and the first middle frame 100 are an integral part, and the second rear cover 320 and the second middle frame 110 are an integral part.

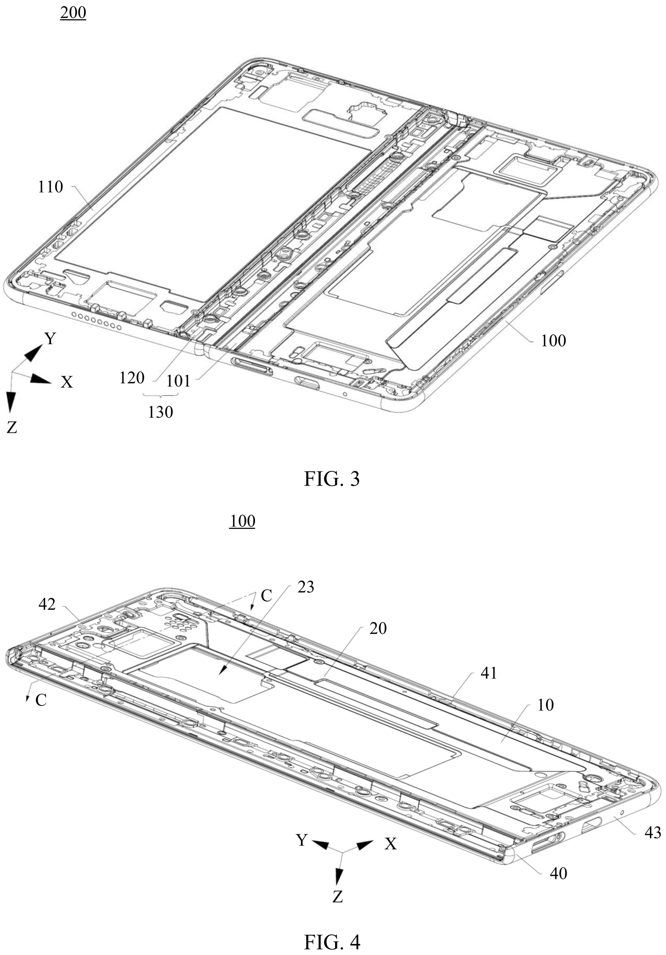

Refer to FIG. 3 as well. FIG. 3 is a schematic diagram of a structure of a middle frame 200 in the electronic device 500 shown in FIG. 2.

The first middle frame 100 is provided with a first accommodation groove 101, and the second middle frame 110 is provided with a second accommodation groove 120. The first middle frame 100 and the second middle frame 110 are disposed side by side, and the first accommodation groove 101 and the second accommodation groove 120 communicate with each other to jointly form an accommodation groove 130. The rotating shaft 540 is mounted in the accommodation groove 130, and is connected to the first middle frame 100 and the second middle frame 110, to implement a rotational connection between the first middle frame 100 and the second middle frame 110. When the first middle frame 100 rotates, the second middle frame 110 is driven to rotate by using the rotating shaft 540, thereby implementing folding or unfolding of the electronic device 500.

The display screen 400 includes a first part 410, a second part 420, and a foldable part 430. The foldable part 430 is located between the first part 410 and the second part 420, and the foldable part 430 may be bent in the Y direction. The first part 410, the second part 420, and the foldable part 430 jointly constitute the display screen 400. In this embodiment, the display screen 400 is a flexible display screen 400. The display screen 400 is mounted on the middle frame 200, and is fixedly connected to the middle frame 200. The first part 410 is mounted on the first middle frame 100, the second part 420 is mounted on the second middle frame 110, and the foldable part 430 is opposite to the rotating shaft 540. When the first middle frame 100 and the second middle frame 110 rotate relative to each other by using the rotating shaft 540, the first part 410 and the second part 420 of the display screen 400 are driven to rotate relative to each other, and the foldable part 430 is bent.

The rear cover 300 is mounted on a side that is of the middle frame 200 and that faces away from the display screen 400. The first rear cover 310 is mounted on the first middle frame 100, and is fixedly connected to the first middle frame 100. The second rear cover 320 is mounted on the second middle frame 110, and is fixedly connected to the second middle frame 110.

The first middle frame 100 and the second middle frame 110 rotate relative to each other by using the rotating shaft 540. When the first middle frame 100 and the second middle frame 110 rotate in a direction close to each other, the first rear cover 310 and the second rear cover 320 are driven to rotate in a direction close to each other, and the display screen 400 is driven to be folded, so that the electronic device 500 is in a folded state. When the electronic device 500 is in a folded state, the foldable part 430 of the display screen 400 is bent, and the first part 410 and the second part 420 are opposite to each other. In this case, the display screen 400 is located between the first middle frame 100 and the second middle frame 110, so that a probability of damage to the display screen 400 can be greatly reduced, thereby effectively protecting the display screen 400.

When the first middle frame 100 and the second middle frame 110 rotate in a direction away from each other, the first rear cover 310 and the second rear cover 320 are driven to rotate in a direction away from each other, and the display screen 400 is driven to be unfolded, so that the electronic device 500 is in an unfolded state. When the electronic device 500 is in an unfolded state, the foldable part 430 is unfolded, and the first part 410 and the second part 420 are unfolded relative to each other. In this case, a display surface of the display screen 400 is approximately a flat surface, and has a large-area display region, so that large-screen display of the electronic device 500 is implemented, and user experience is improved.

In an implementation, the electronic device 500 may include a second display screen. There is one rear cover 300. The rear cover 300 is mounted on the first middle frame 100, and is fixedly connected to the first middle frame 100. The second display screen is mounted on the second middle frame 110, and is fixedly connected to the second middle frame 110. That is, in this implementation, the second display screen is used to replace the second rear cover 320, so that normal use of the electronic device 500 in a folded state can be implemented.

It should be noted that the first middle frame 100 and the second middle frame 110 are approximately symmetrical or fully symmetrical structures. The following specifically describes a structure of the first middle frame 100.

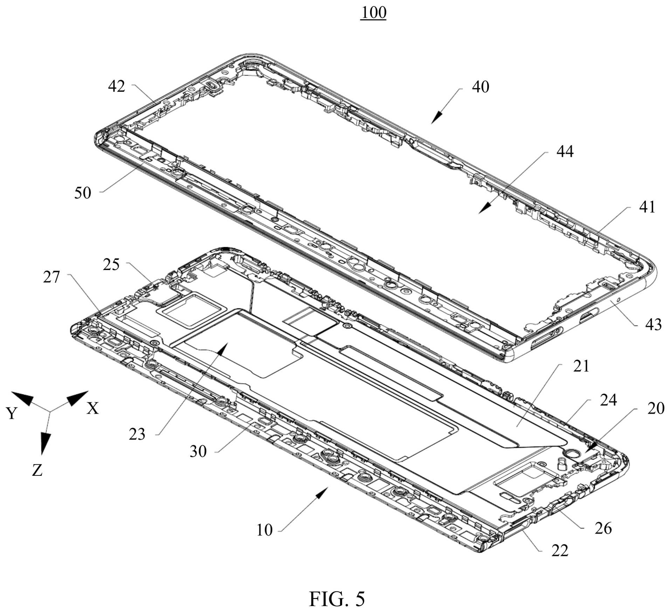

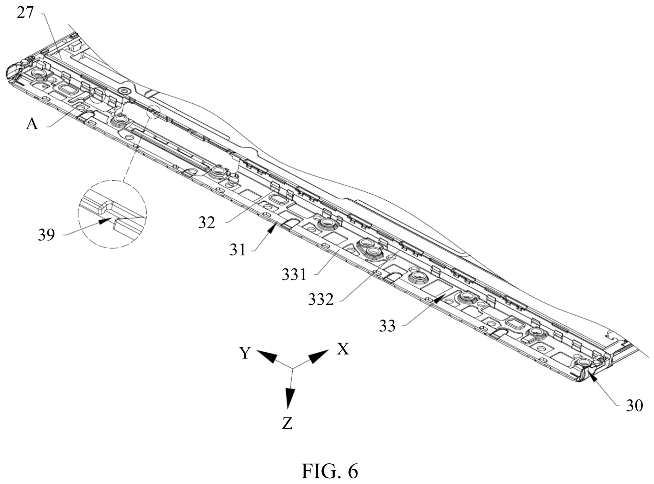

Refer to FIG. 4 to FIG. 6. FIG. 4 is a schematic diagram of a structure of a first middle frame 100 in the middle frame 200 shown in FIG. 3. FIG. 5 is a schematic diagram of an exploded structure of the first middle frame 100 shown in FIG. 4. FIG. 6 is a schematic diagram of a structure of a frame body 10 in the first middle frame 100 shown in FIG. 4.

The first middle frame 100 includes a frame body 10 and an overmolded part 40. The overmolded part 40 is formed on a surface of the frame body 10, and is fixedly connected to the frame body 10. The frame body 10 includes a middle plate 20 and a first mounting frame 30. The first mounting frame 30 is disposed side by side with the middle plate 20 in the X direction, and is fixedly connected to the middle plate. The middle plate 20 includes an upper surface 21 and a lower surface 22. The upper surface 21 and the lower surface 22 are opposite to each other, and are respectively located on two opposite sides in the Z direction. The middle plate 20 is provided with a plurality of through slots 23. The through slot 23 runs through the upper surface 21 and the lower surface 22. The through slot 23 is configured to mount a component such as a camera of the electronic device 500. The middle plate 20 further includes a first side part 24, a second side part 25, a third side part 26, and a fourth side part 27. The first side part 24 and the fourth side part 27 are opposite to each other, and are respectively located on two opposite sides in the X direction. The second side part 25 and the third side part 26 are opposite to each other, and are respectively located on two opposite sides in the Y direction. Both the first side part 24 and the fourth side part 27 are connected between the second side part 25 and the third side part 26. It should be noted that the first side part 24, the second side part 25, the third side part 26, and the fourth side part 27 are edge parts of the middle plate 20.

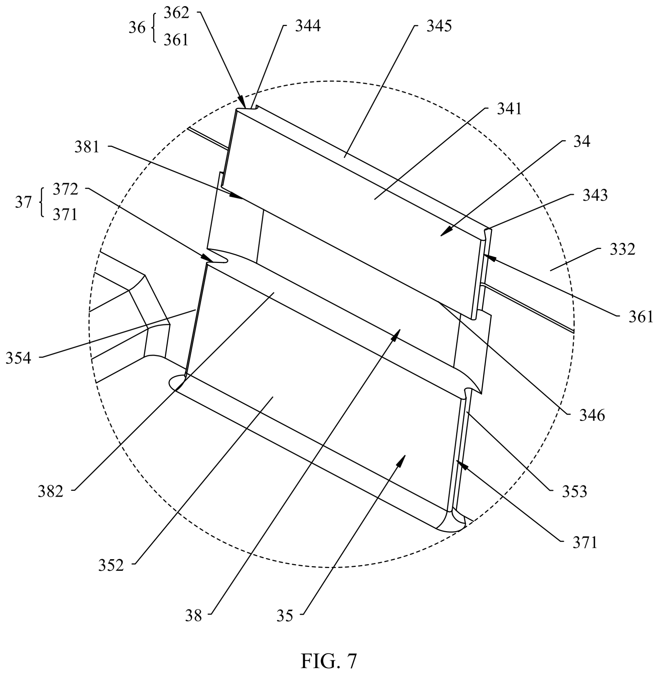

Also refer to FIG. 7. FIG. 7 is an enlarged schematic diagram of a structure of a region A of the frame body 10 shown in FIG. 6.

The first mounting frame 30 includes a body 31 and a convex rib 32. The body 31 is disposed side by side with the middle plate 20 in the X direction, and is fixedly connected to the fourth side part 27 of the middle plate 20. The body 31 is provided with a first mounting groove 33. The first mounting groove 33 is L-shaped. An extension direction of the first mounting groove 33 is parallel to the Y direction. The first mounting groove 33 includes a first bottom wall 331 and a first sidewall 332. The first sidewall 332 is fixedly connected to the first bottom wall 331. In this embodiment, the first sidewall 332 is parallel to a YZ plane. A small included angle may also be formed between the first sidewall 332 and the YZ plane, for example, 5 degrees or 10 degrees. In this embodiment, the first sidewall 332 is perpendicularly connected to the first bottom wall 331. In another embodiment, the included angle between the first sidewall 332 and the first bottom wall 331 may be slightly greater than 90 degrees, or slightly less than 90 degrees.

There are a plurality of groups of convex ribs 32. The plurality of groups of convex ribs 32 are protruded from the first sidewall 332, and are disposed at intervals on the first sidewall 332 in the Y direction. Each group of convex ribs 32 includes a first convex rib 34 and a second convex rib 35. The first convex rib 34 includes a first surface 341, a first side surface 343, a second side surface 344, a third side surface 345, and a fourth side surface 346. The first surface 341 is a surface that is of the first convex rib 34 and that is away from the first sidewall 332. The first side surface 343 and the second side surface 344 are opposite to each other, and are respectively located on two opposite sides in the Y direction. The third side surface 345 and the fourth side surface 346 are opposite to each other, and are respectively located on two opposite sides in the Z direction. The first side surface 343, the third side surface 345, the second side surface 344, and the fourth side surface 346 are head-to-tail connected, and are all connected between the first surface 341 and the first sidewall 332.

The first convex rib 34 is provided with a first limiting groove 36. The first limiting groove 36 includes a first sub-limiting groove 361 and a second sub-limiting groove 362. In a direction from the first surface 341 to the first sidewall 332, the first side surface 343 is recessed inwardly toward the first convex rib 34, and the first sub-limiting groove 361 is formed between the first side surface and the first sidewall 332. In a direction from the first surface 341 to the first sidewall 332, the second side surface 344 is recessed inwardly toward the first convex rib 34, and the second sub-limiting groove 362 is formed between the second side surface and the first sidewall 332. It may be understood that, an edge part that is of the first convex rib 34 and that is close to the first side surface 343 is a groove wall of the first sub-limiting groove 361, and an edge part that is of the first convex rib 34 and that is close to the second side surface 344 is a groove wall of the second sub-limiting groove 362. Both the groove wall of the first sub-limiting groove 361 and the groove wall of the second sub-limiting groove 362 are opposite to the first sidewall 332.

In this embodiment, both the first side surface 343 and the second side surface 344 are curved surfaces. It may be understood that the first sub-limiting groove 361 may be obtained by disposing a chamfer on the first side surface 343. The second sub-limiting groove 362 may be obtained by disposing a chamfer on the second side surface 344. A cross-section of the first convex rib 34 along an XY plane is approximately trapezoidal. In another embodiment, the first side surface 343 and the second side surface 344 may be inclined surfaces, and a cross-section of the first convex rib 34 along an XY plane is trapezoidal. Alternatively, the first side surface 343 is a curved surface, and the second side surface 344 is an inclined surface. Alternatively, the first side surface 343 is an inclined surface, and the second side surface 344 is a curved surface. Both the first sub-limiting groove 361 and the second sub-limiting groove 362 are configured to be connected to the overmolded part 40 through engagement, to prevent the overmolded part 40 from being separated from the frame body 10 in the X direction.

In an implementation, the first limiting groove 36 may further include a fifth sub-limiting groove and a sixth sub-limiting groove (not shown in the figure). In a direction from the first surface 341 to the first sidewall 332, the third side surface 345 is recessed inwardly toward the first convex rib 34, and the fifth sub-limiting groove is formed between the third side surface and the first sidewall 332. In a direction from the first surface 341 to the first sidewall 332, the fourth side surface 346 is recessed inwardly toward the first convex rib 34, and the sixth sub-limiting groove is formed between the fourth side surface and the first sidewall 332. The fifth sub-limiting groove and the sixth sub-limiting groove are configured to be connected to the overmolded part 40 through engagement, to further improve stability of a connection between the overmolded part 40 and the frame body 10.

A structure of the second convex rib 35 is the same as or approximately the same as a structure of the first convex rib 34. The second convex rib 35 is fixedly connected to the first sidewall 332, and is disposed side by side with and spaced apart from the first convex rib 34 in a width direction of the first sidewall 332. That is, the first convex rib 34 is disposed side by side with and spaced apart from the second convex rib 35 in the Z direction on the first sidewall 332.

The second convex rib 35 includes a second surface 352, a fifth side surface 353, and a sixth side surface 354. The second surface 352 is a surface that is of the second convex rib 35 and that is away from the first sidewall 332. The fifth side surface 353 and the sixth side surface 354 are opposite each other, and are respectively located on two opposite sides in the Y direction, and both the fifth side surface 353 and the sixth side surface 354 are connected between the second surface 352 and the first sidewall 332. The second convex rib 35 is provided with a second limiting groove 37. The second limiting groove 37 includes a third sub-limiting groove 371 and a fourth sub-limiting groove 372. In a direction from the second surface 352 to the first sidewall 332, the fifth side surface 353 is recessed inwardly toward the second convex rib 35, and the third sub-limiting groove 371 is formed between the fifth side surface and the first sidewall 332. In a direction from the second surface 352 to the first sidewall 332, the sixth side surface 354 is recessed inwardly toward the second convex rib 35, and the fourth sub-limiting groove 372 is formed between the sixth side surface and the first sidewall 332. It may be understood that, an edge part that is of the second convex rib 35 and that is close to the fifth side surface 353 is a groove wall of the third sub-limiting groove 371, and an edge part that is of the second convex rib 35 and that is close to the sixth side surface 354 is a groove wall of the fourth sub-limiting groove 372. Both the groove wall of the third sub-limiting groove 371 and the groove wall of the fourth sub-limiting groove 372 are opposite to the first sidewall 332.

In this embodiment, both the fifth side surface 353 and the sixth side surface 354 are curved surfaces. It may be understood that the third sub-limiting groove 371 may be obtained by disposing a chamfer on the fifth side surface 353. The fourth sub-limiting groove 372 may be obtained by disposing a chamfer on the sixth side surface 354. In another embodiment, the fifth side surface 353 and the sixth side surface 354 may be inclined surfaces, and a cross-section of the first convex rib 34 along the XY plane is trapezoidal. Both the third sub-limiting groove 371 and the fourth sub-limiting groove 372 are configured to be connected to the overmolded part 40 through engagement, to prevent the overmolded part 40 from being separated from the frame body 10 in the Y direction.

The first mounting frame 30 is further provided with a plurality of retention grooves 38. One retention groove 38 is correspondingly disposed between the first convex rib 34 and the second convex rib 35 of each group of convex ribs 32. In this embodiment, the retention groove 38 is recessed on the first sidewall 332, and is located between the first convex rib 34 and the second convex rib 35. The retention groove 38 includes a first abutting wall 381 and a second abutting wall 382. The first abutting wall 381 and the second abutting wall 382 are respectively located on two opposite sides of the retention groove 38 in the Z direction. In this embodiment, the retention groove 38 is recessed on the first sidewall 332. The first abutting wall 381 and the second abutting wall 382 are inner walls of the retention groove 38. The retention groove 38 is configured to be connected to the overmolded part 40 in the width direction of the first sidewall 332 through engagement, to prevent the overmolded part 40 from being separated from the frame body 10 in the width direction of the first sidewall 332, namely, the Z direction.

In another implementation, the retention groove 38 may be formed by a gap between the first convex rib 34 and the second convex rib 35. A bottom wall of the retention groove 38 is flush with the first sidewall 332. The first abutting wall 381 is a side surface that is of the first convex rib 34 and that faces the retention groove 38, that is, the first abutting wall 381 is the third side surface 345. The second abutting wall 382 is a side surface that is of the second convex rib 35 and that faces the retention groove 38.

Continue to refer to FIG. 6. The first mounting frame 30 is further provided with a plurality of engagement grooves 39. The plurality of engagement grooves 39 are disposed on the first sidewall 332, and extend toward the middle plate 20. In a direction from a bottom wall to an opening of the engagement groove 39, a size of the engagement groove 39 gradually decreases in the Y direction. In this embodiment, a shape of the engagement groove 39 is a right-angled trapezoid. In another embodiment, a shape of the engagement groove 39 may be an isosceles trapezoid. The engagement groove 39 is configured to fit with the overmolded part 40.

In this embodiment, materials of the frame body 10 are all magnesium alloy. In another embodiment, the frame body 10 may be made of a material such as aluminum alloy, titanium alloy, or stainless steel. In this embodiment, the first convex rib 34 and the second convex rib 35 are integrally formed with the frame body 10. Specifically, the first convex rib 34 and the second convex rib 35 may be integrally formed through die-casting. In an actual manufacturing process of the frame body 10, first, a frame body monomer with a convex rib 32 is produced by using a die-casting method, and a side surface of the convex rib 32 is provided with a limiting groove. Then, a protrusion 59 is cut through CNC to obtain a retention groove 38, and the rib 32 is divided into a first convex rib 34 and a second convex rib 35 that are disposed side by side.

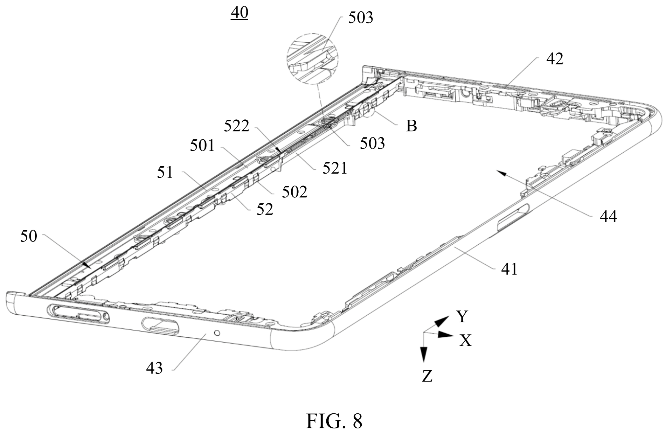

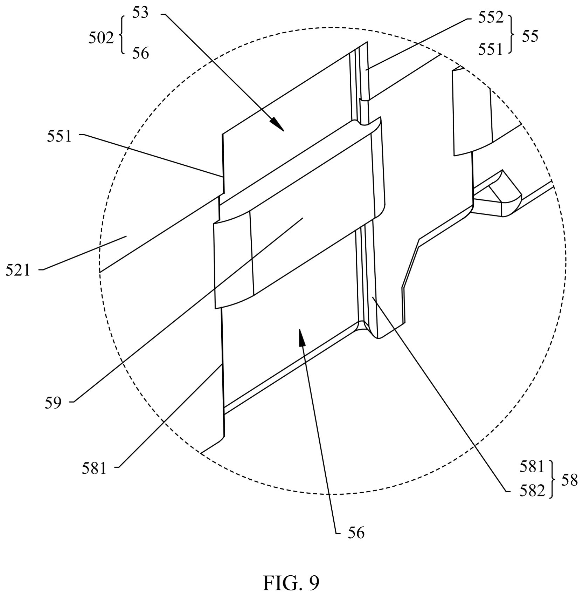

Refer to FIG. 8 and FIG. 9. FIG. 8 is a schematic diagram of a structure of an overmolded part 40 in the first middle frame 100 shown in FIG. 5, and FIG. 9 is a schematic diagram of an enlarged structure of a region B in the overmolded part 40 shown in FIG. 8.

In this embodiment, a material of the overmolded part 40 is a polycarbonate (PC)/carbon fiber composite material. In another embodiment, the overmolded part 40 may be of another plastic material. The overmolded part 40 is approximately of a structure of a rectangular frame body 10. The overmolded part 40 includes a first border frame 41, a second border frame 42, a third border frame 43, and a second mounting frame 50. The first border frame 41 and the second mounting frame 50 are respectively located on two opposite sides in the X direction. The second border frame 42 and the third border frame 43 are respectively located on two opposite sides in the Y direction, and both the second border frame 42 and the third border frame 43 are connected between the first border frame 41 and the second mounting frame 50. The overmolded part 40 is further provided with mounting space 44. The mounting space 44 runs through the overmolded part 40 in the thickness direction. It may be understood that the first border frame 41, the second border frame 42, the third border frame 43, and the second mounting frame 50 are head-to-tail connected, and enclose the mounting space 44.

The second mounting frame 50 is L-shaped. The second mounting frame 50 includes a bottom plate 51 and a side plate 52. The bottom plate 51 is fixedly connected to the side plate 52. In this embodiment, the bottom plate 51 is perpendicular to the side plate 52. In another embodiment, an included angle between the bottom plate 51 and the side plate 52 may be slightly greater than 90 degrees, or slightly less than 90 degrees. The side plate 52 includes a second sidewall 521 and a third sidewall 522. The second sidewall 521 and the third sidewall 522 are opposite to each other. The second mounting frame 50 is connected between the second border frame 42 and the third border frame 43, the side plate 52 faces the first border frame 41, and the second sidewall 521 faces the mounting space 44. The second mounting frame 50 is provided with a second mounting groove 501. The second mounting groove 501 is enclosed by the bottom plate 51 and the side plate 52. The third sidewall 522 faces the second mounting groove 501. The bottom plate 51 is located on a surface of the second mounting groove 501, and is a bottom wall of the second mounting groove 501, and the third sidewall 522 is a sidewall of the second mounting groove 501.

The second mounting frame 50 further includes a protrusion 59. There are a plurality of protrusions 59. The plurality of protrusions 59 are fixedly connected to the second sidewall 521 of the side plate 52. The protrusions 59 are disposed in a one-to-one correspondence with the retention grooves 38. In addition, a structure of the protrusion 59 matches a structure of the retention groove 38. When the overmolded part 40 is formed on the frame body 10, the protrusion 59 is located in the retention groove 38.

The second sidewall 521 is provided with a plurality of groups of grooves 502. The plurality of groups of grooves 502 are disposed at intervals in the Y direction on an inner surface, and are disposed in a one-to-one correspondence with the plurality of groups of convex ribs 32. Each group of grooves 502 includes a first groove 53 and a second groove 56. The first groove 53 and the second groove 56 are respectively located on two opposite sides of the protrusion 59 in the Z direction. A structure of the first groove 53 matches a structure of the first convex rib 34. A sidewall of the first groove 53 is provided with a first engagement part 55. The first engagement part 55 includes a first sub-engagement part 551 and a second sub-engagement part 552. The first sub-engagement part 551 and the second sub-engagement part 552 are respectively disposed on two opposite sidewalls of the first groove 53. In this embodiment, the first sub-engagement part 551 is of a curved protruding structure. In addition, the first sub-engagement part 551 matches a structure of the first sub-limiting groove 361. The first sub-engagement part 551 is formed in the first sub-limiting groove 361, and is connected to the first sub-limiting groove 361 through engagement. In this embodiment, the second sub-engagement part 552 is of a curved protruding structure. In addition, the second sub-engagement part 552 matches a structure of the second sub-limiting groove 362. The second sub-engagement part 552 is formed in the second sub-limiting groove 362, and is connected to the second sub-limiting groove 362 through engagement.

The second groove 56 is located on a side that is of the protrusion 59 and that faces away from the first groove 53. A structure of the second groove 56 matches a structure of the second convex rib 35. A sidewall of the second groove 56 is provided with a second engagement part 58. The second engagement part 58 includes a third sub-engagement part 581 and a fourth sub-engagement part 582. The third sub-engagement part 581 and the fourth sub-engagement part 582 are respectively disposed two on opposite sidewalls of the second groove 56. In this embodiment, the third sub-engagement part 581 is of a curved protruding structure. In addition, the third sub-engagement part 581 matches a structure of the third sub-limiting groove 371. The third sub-engagement part 581 is formed in the third sub-limiting groove 371, and is connected to the third sub-limiting groove 371 through engagement. In this embodiment, the fourth sub-engagement part 582 is of a curved protruding structure. In addition, the fourth sub-engagement part 582 matches a structure of the fourth sub-limiting groove 372. The fourth sub-engagement part 582 is formed in the fourth sub-limiting groove 372, and is connected to the fourth sub-limiting groove 372 through engagement.

The second mounting frame 50 is further provided with a plurality of engagement protrusions 503. The plurality of engagement protrusions 503 are fastened to the second sidewall 521 of the side plate 52, and are disposed in a one-to-one correspondence with the plurality of engagement grooves 39. The engagement protrusion 503 is trapezoidal, and matches a shape of the engagement groove 39. The engagement protrusion 503 is formed in the engagement groove 39, and is connected to the engagement groove 39 through engagement.

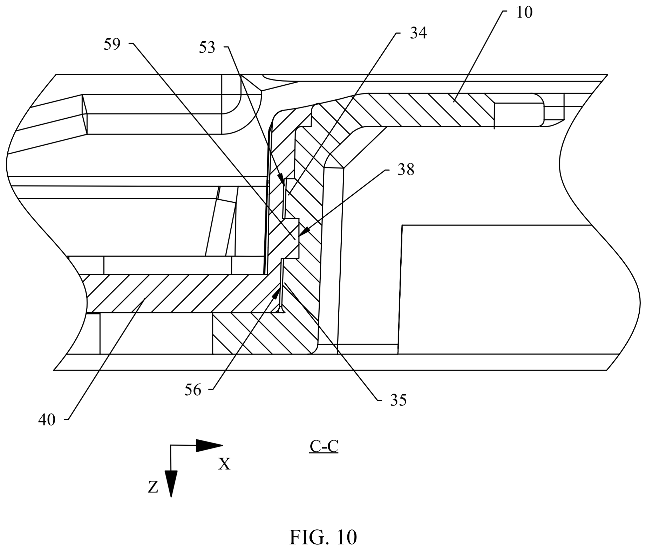

Refer to FIG. 4 and FIG. 10 together. FIG. 10 is a schematic diagram of a partial cross-sectional structure of the first middle frame 100 shown in FIG. 4 in a C-C direction.

The overmolded part 40 is formed on the frame body 10, the first border frame 41, the second border frame 42, and the third border frame 43 are all formed on the middle plate 20, and the second mounting frame 50 is formed on the first mounting frame 30. The first border frame 41 is formed on an outer surface of the first side part 24, and is fixedly connected to the first side part 24. The second border frame 42 is formed on an outer surface of the second side part 25, and is fixedly connected to the second side part 25. The third border frame 43 is formed on an outer surface of the third side part 26, and is fixedly connected to the third side part 26. A middle part of the middle plate 20 is opposite to the mounting space 44, and the through slot 23 is exposed through the mounting space 44.

The second mounting frame 50 is formed in the first mounting groove 33 of the first mounting frame 30. The protrusions 59 are disposed in a one-to-one correspondence with the retention grooves 38. One protrusion 59 is located in one retention groove 38, and is connected to the retention groove 38 through engagement. The first convex ribs 34 are disposed in a one-to-one correspondence with the first grooves 53, and one first convex rib 34 is located in one first groove 53. The first engagement part 55 is located in the first limiting groove 36, and is connected to the first limiting groove 36 through engagement. The first sub-engagement part 551 is engaged in the first sub-limiting groove 361, and the second sub-engagement part 552 is engaged in the second sub-limiting groove 362. The second convex ribs 35 are disposed in a one-to-one correspondence with the second grooves 56, and one second convex rib 35 is located in one second groove 56. The second engagement part 58 is located in the second limiting groove 37, and is connected to the second limiting groove 37 through engagement. The third sub-engagement part 581 is engaged in the third sub-limiting groove 371, and the fourth sub-engagement part 582 is engaged in the fourth sub-limiting groove 372. The engagement protrusions 503 are disposed in a one-to-one correspondence with the engagement grooves 39, and one engagement protrusion 503 is located in one first engagement groove 39, and is engaged with a corresponding first engagement groove 39.

It may be understood that, after the overmolded part 40 is formed on the frame body 10, an outer side surface of the first border frame 41, an outer side surface of the second border frame 42, and an outer side surface of the third border frame 43 are exposed from side surfaces of the electronic device 500, and form border frames of the electronic device 500. The second mounting groove 501 is a first accommodation groove 101 of the electronic device 500, and is configured to mount the rotating shaft 540 of the electronic device 500.

It should be noted that the overmolded part 40 is formed on the frame body 10 through injection molding. All the foregoing connection relationships are directly formed during injection molding. For a specific processing method, refer to the following detailed descriptions.

The middle frame 200 in this embodiment includes the frame body 10 of the metal material and the overmolded part 40 of the plastic material. Compared with a middle frame 200 of pure metal, the middle frame 200 in this embodiment has a lighter mass, so that a weight can be reduced, thereby helping implement a lightweight design of the electronic device 500, and improve user experience. For example, compared with an aluminum profile middle frame 200, the middle frame 200 provided in this embodiment may achieve weight reduction of approximately 11%. In addition, in this embodiment, the overmolded part 40 covers an outer surface of the metal frame body 10, so that the frame body 10 can be protected, and the middle frame 200 can be prevented from being corroded by salt spray or the like, thereby improving corrosion resistance of the middle frame 200. Therefore, the electronic device 500 can be used stably in a corrosion environment without failure, to improve durability of the electronic device 500.

When a protection effect and structural strength in the shaft region of the middle frame 200 may be implemented, the middle frame 200 provided in this embodiment has a smaller space requirement. For example, in this embodiment, when a thickness of the overmolded part 40 is 0.25 mm and a thickness of the frame body 10 is 0.65 mm, a protection effect and structural strength in the shaft region can be implemented, and therefore the electronic device 500 can be lightened and thinned. It should be explained that the "shaft region" described herein is a region in which the rotating shaft 540 is mounted, namely, a region in which the first mounting frame 30 and the second mounting frame 50 are located.

In this embodiment, the first limiting groove 36, the second limiting groove 37, and the retention groove 38 are disposed on the first mounting frame 30. Therefore, when the overmolded part 40 is formed on the surface of the frame body 10, the first engagement part 55 is correspondingly formed in the first limiting groove 36, the first limiting groove 36 is connected to the first engagement part 55 through engagement in the direction (the X direction) perpendicular to the first sidewall 332, the second engagement part 58 is correspondingly formed in the second limiting groove 37, the second limiting groove 37 is connected to the second engagement part 58 through engagement in the X direction, the protrusion 59 is correspondingly formed in the retention groove 38, and the retention groove 38 is connected to the protrusion 59 through engagement in the width direction (the Z direction) of the first sidewall 332. The first limiting groove 36 and the second limiting groove 37 play a limiting role on the overmolded part 40 in the X direction, so that the overmolded part 40 can be prevented from being separated from the frame body 10 in the X direction. The retention groove 38 plays a limiting role on the overmolded part 40 in the Z direction, so that the overmolded part 40 can be prevented from being separated from the frame body 10 in the Z direction. This can improve stability of a connection between the overmolded part 40 and the frame body 10, prevent the overmolded part 40 from being separated from the frame body 10 in the shaft region, and implement a retention effect between the frame body 10 and the overmolded part 40. It should be explained that the "retention effect" herein means an effect that when a force is exerted on the overmolded part 40, the overmolded part 40 is not prone to be separated from the frame body 10.

The first convex rib 34 and the first limiting groove 36 are disposed on the first mounting frame 30. Therefore, when the overmolded part 40 is formed on the surface of the frame body 10, the first groove 53 is correspondingly formed on an outer surface of the first convex rib 34, and the first engagement part 55 is correspondingly formed in the first limiting groove 36. In this way, when a force is exerted on the overmolded part 40 in the direction perpendicular to the first sidewall 332, namely, in the X direction, the first engagement part 55 abuts against the groove wall of the first limiting groove 36, and the groove wall of the first limiting groove 36 plays a limiting role on the overmolded part 40, so that the overmolded part 40 can be prevented from being separated from the frame body 10 in the X direction. In addition, in this embodiment, a plurality of first convex ribs 34 are disposed on the first sidewall 332 in the Y direction, and a plurality of first limiting grooves 36 are formed. A plurality of first grooves 53 are disposed on the second sidewall 521 in the Y direction, and a plurality of first engagement parts 55 are formed. Therefore, the frame body 10 plays a limiting role on the overmolded part 40 at a plurality of positions in the Y direction, so that the overmolded part 40 can be further prevented from being separated from the overmolded part 40 in the direction perpendicular to the first sidewall 332, thereby further improving stability of a connection between the overmolded part 40 and the frame body 10.

In addition, the second convex rib 35 and the second limiting groove 37 are disposed on the first mounting frame 30. Therefore, when the overmolded part 40 is formed on the surface of the frame body 10, the second groove 56 is correspondingly formed on an outer surface of the second convex rib, and the second engagement part 58 is correspondingly formed in the second limiting groove 37. In this way, when a force is exerted on the overmolded part 40 in the direction perpendicular to the first sidewall 332, the second engagement part 58 abuts against the groove wall of the second limiting groove 37, and the groove wall of the second limiting groove 37 further plays a limiting role on the overmolded part 40, thereby further improving stability of a connection between the overmolded part 40 and the frame 10, and further preventing the overmolded part 40 from being separated from the frame body 10 in the X direction. In addition, in this embodiment, a plurality of second convex ribs 35 are disposed on the first sidewall 332 in the Y direction, and a plurality of second limiting grooves 37 are formed. A plurality of second grooves 56 are disposed on the second sidewall 521 in the Y direction, and a plurality of second engagement parts 58 are formed. Therefore, the frame body 10 plays a limiting role on the overmolded part 40 at a plurality of positions in the Y direction, so that the overmolded part 40 can be further prevented from being separated from the overmolded part 40 in the direction perpendicular to the first sidewall 332, thereby further improving stability of a connection between the overmolded part 40 and the frame body 10.

In this embodiment, the retention groove 38 is disposed on the frame body 10. Therefore, when the overmolded part 40 is formed on the surface of the frame body 10, the protrusion 59 is correspondingly formed in the retention groove 38. In this way, when a force is exerted on the overmolded part 40 in the Z direction, the abutting wall of the retention groove 38 abuts against the protrusion 59, and the abutting wall plays a limiting role on the overmolded part 40, so that the overmolded part 40 can be prevented from being separated from the frame body 10 in the Z direction. For example, when a force is exerted on the overmolded part 40 in a negative direction of the Z-axis, the protrusion 59 abuts against the first abutting wall 381, and the first abutting wall 381 plays a limiting role on the protrusion 59, so that the overmolded part 40 can be prevented from being separated from the frame body 10 in the negative direction of the Z-axis. When a force is exerted on the overmolded part 40 in a positive direction of the Z-axis, the protrusion 59 abuts against the second abutting wall 382, and the second abutting wall 382 plays a limiting role on the protrusion 59, so that the overmolded part 40 can be prevented from being separated from the frame body 10 in the positive direction of the Z-axis.

In addition, in this embodiment, a plurality of retention grooves 38 are disposed on the first sidewall 332 in the Y direction, and a plurality of protrusions 59 are disposed on the second sidewall 521 in the Y direction. Therefore, the frame body 10 plays a limiting role on the overmolded part 40 at a plurality of positions in the Y direction, so that the overmolded part 40 can be further prevented from being separated from the overmolded part 40 in the width direction of the first sidewall 332, thereby further improving stability of a connection between the overmolded part 40 and the frame body 10.

In addition, in this embodiment, the engagement groove 39 is disposed on the first sidewall 332. Therefore, when the overmolded part 40 is formed on the surface of the frame body 10, the engagement protrusion 503 is correspondingly formed in the engagement groove 39. Therefore, when a force is exerted on the overmolded part 40 in the direction perpendicular to the first sidewall 332, that is, when a force is exerted on the overmolded part 40 in the X direction, the engagement protrusion 503 abuts against a groove wall of the engagement groove 39, and the groove wall of the engagement groove 39 plays a limiting role on the engagement protrusion 503, so that the overmolded part 40 can be further prevented from being separated from the frame body 10 in the X direction, thereby further improving stability of a connection the overmolded part 40 and the frame body 10.

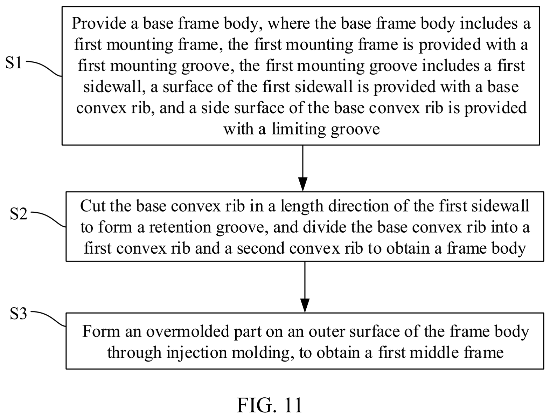

Refer to FIG. 11. FIG. 11 is a flowchart of manufacturing the first middle frame 100 shown in FIG. 4.

A process of manufacturing the first middle frame 100 includes:
S1. Provide a base frame body, where the base frame body includes a first mounting frame, the first mounting frame is provided with a first mounting groove, the first mounting groove includes a first sidewall, the first sidewall is provided with a base convex rib, and a side surface of the base convex rib is provided with a limiting groove.
S2. Cut the base convex rib in a length direction of the first sidewall to form a retention groove 38, and divide the base convex rib into a first convex rib 34 and a second convex rib 35 to obtain a frame body 10.
S3. Form an overmolded part 40 on an outer surface of the frame body 10 through injection molding, to obtain a first middle frame 100.

In S1, the base frame body is manufactured through die-casting by using a mold. A material of the base frame body is magnesium alloy, aluminum alloy, titanium alloy, stainless steel, or the like. There are a plurality of base convex ribs, and the plurality of base convex ribs are disposed at intervals in the length direction of the first sidewall. The base frame body further includes a middle plate, and the middle plate is fixedly connected to a side of the first mounting frame.

It should be noted that the base convex rib and the limiting groove are directly formed in the mold during die-casting of the base frame body. The base convex rib includes two side surfaces disposed in the length direction of the first sidewall. The two side surfaces are respectively recessed inwardly toward the convex rib 32, and a limiting groove is formed between each of the two side surfaces and the first sidewall. In this embodiment, a groove wall of the limiting groove is a curved surface. In another embodiment, the groove wall of the limiting groove may be an inclined surface.

In S2, a surface of the base convex rib is cut through CNC (computer numerical control machine tool) to obtain the retention groove 38. After the cutting, the base convex rib is divided into two parts, which are respectively the first convex rib 34 and the second convex rib 35, thereby obtaining the frame body 10. The first convex rib 34 is disposed side by side with and spaced apart from the second convex rib 35 in a width direction of the first sidewall. A first limiting groove 36 is formed between a side surface of the first convex rib 34 and the first sidewall, and a second limiting groove 37 is formed between a side surface of the second convex rib 35 and the first sidewall.

In S3, a material of the overmolded part 40 is plastic. In an injection molding process, the frame body 10 is first placed in a mold, then a liquid plastic raw material is injected into the mold, then the plastic raw material covers a surface of the frame body 10 through pressurization, and then the plastic raw material is molded through cooling to obtain the overmolded part 40. In this embodiment, the overmolded part 40 covers a surface of the first mounting frame 30 and a side edge of the middle plate 20.

The overmolded part 40 includes a second mounting frame 50 and a border frame. The border frame is fixedly connected to the second mounting frame 50. The second mounting frame 50 includes a bottom plate 51 and a side plate 52. The side plate 52 includes a second sidewall 521, and the second sidewall 521 faces the border frame. After the overmolded part 40 is formed on an outer surface of the frame body 10 through injection molding, a first groove 53 is correspondingly formed on an outer surface of the first convex rib 34, a first engagement part 55 is correspondingly formed in the first limiting groove 36, a second groove 56 is correspondingly formed on an outer surface of the second convex rib 35, a second engagement part 58 is correspondingly formed in the second limiting groove 37, and a protrusion 59 is correspondingly formed in the retention groove 38.

In this embodiment, the overmolded part 40 is formed on a surface of the frame body 10 through injection molding, so that a mass of the middle frame 200 can be reduced, thereby helping implement a lightweight design of the electronic device 500, and improve user experience. In addition, the overmolded part 40 is formed on the surface of the metal frame body 10 through injection molding, so that the frame body 10 can be protected, and the middle frame 200 can be prevented from being corroded by salt spray or the like, thereby improving corrosion resistance of the middle frame 200. Therefore, the electronic device 500 can be used stably in a corrosion environment without failure, to improve durability of the electronic device 500.

In addition, in this embodiment, the first limiting groove 36 and the second limiting groove 37 are disposed on the frame body 10. Therefore, when the overmolded part 40 is formed on the surface of the frame body 10, the first engagement part 55 is correspondingly formed in the first limiting groove 36, and the second engagement part 58 is correspondingly formed in the second limiting groove 37, so that the first limiting groove 36 plays a limiting role on the first engagement part 55, and the second limiting groove 37 plays a limiting role on the second engagement part 58. In this way, the overmolded part 40 can be prevented from being separated from the frame body 10 when a force is exerted on the overmolded part 40 in the direction (the X direction) perpendicular to the first sidewall. In addition, the retention groove 38 is disposed on the frame body 10. Therefore, when the overmolded part 40 is formed on the surface of the frame body 10, the protrusion 59 is correspondingly formed in the retention groove 38, so that the retention groove 38 plays a limiting role on the protrusion 59. In this way, when a force is exerted on the overmolded part 40 in the width direction (the Z direction) of the first sidewall, the overmolded part 40 can be prevented from being separated from the frame body 10, thereby improving stability of a connection between the overmolded part 40 and the frame body 10, and preventing the overmolded part 40 from being separated from the frame body 10 in the shaft region.

The foregoing descriptions are only some embodiments and implementations of this application, and are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A housing, comprising: a frame body and an overmolded part, wherein
the frame body comprises a first mounting frame, the first mounting frame is provided with a first mounting groove, the first mounting groove comprises a first sidewall, the first sidewall is provided with a retention groove, the first mounting frame comprises a first convex rib, the first convex rib is fixedly connected to the first sidewall, a side surface of the first convex rib is recessed inwardly toward the first convex rib, and a first limiting groove is formed between the side surface of the first convex rib and the first sidewall;
the overmolded part comprises a second mounting frame, the second mounting frame comprises a second sidewall, the second sidewall is provided with a first groove, a sidewall of the first groove is provided with a first engagement part, the overmolded part further comprises a protrusion, and the protrusion is fixedly connected to the second sidewall; and
the overmolded part is formed on the frame body, the second mounting frame is located in the first mounting groove, the second sidewall is opposite to the first sidewall, the first convex rib is located in the first groove, the first engagement part is located in the first limiting groove, and is engaged with the first limiting groove in a direction perpendicular to the first sidewall, and the protrusion is located in the retention groove, and is engaged with the retention groove in a width direction of the first sidewall.

2. The housing according to claim 1, wherein the side surface of the first convex rib is an inclined surface or a curved surface.

3. The housing according to claim 2, wherein the side surface of the first convex rib comprises a first side surface and a second side surface, the first side surface and the second side surface are opposite to each other, and the first side surface and the second side surface are respectively located on two opposite sides of the first convex rib in a length direction of the frame body;
the first limiting groove comprises a first sub-limiting groove and a second sub-limiting groove, the first sub-limiting groove is formed between the first side surface and the first sidewall, and the second sub-limiting groove is formed between the second side surface and the first sidewall;
the first engagement part comprises a first sub-engagement part and a second sub-engagement part, and the first sub-engagement part and the second sub-engagement part are respectively disposed on two opposite sidewalls of the first groove in a length direction of the overmolded part; and
the overmolded part is formed on the frame body, the first sub-engagement part is located in the first sub-limiting groove, and is engaged with the first sub-limiting groove in the direction perpendicular to the first sidewall, and the second sub-engagement part is located in the second sub-limiting groove, and is engaged with the second sub-limiting groove in the direction perpendicular to the first sidewall.

4. The housing according to claim 3, wherein there are a plurality of first convex ribs, the plurality of first convex ribs are disposed at intervals in a length direction of the first sidewall, the first limiting groove is formed between a side surface of each first convex rib and the first sidewall, there are a plurality of first grooves, the plurality of first grooves are disposed in a one-to-one correspondence with the plurality of first convex ribs, and a sidewall of each first groove is provided with the first engagement part.

5. The housing according to claim 4, wherein there are a plurality of retention grooves, the retention grooves are recessed on the first sidewall, the plurality of retention grooves are disposed at intervals in the length direction of the first sidewall, there are a plurality of protrusions, the plurality of protrusions are disposed in a one-to-one correspondence with the plurality of retention grooves, one protrusion is formed in one retention groove, and the protrusion is engaged with the corresponding retention groove in the width direction of the first sidewall.

6. The housing according to any one of claims 1 to 5, wherein the first mounting frame further comprises a second convex rib, the second convex rib is disposed side by side with and spaced apart from the first convex rib in the width direction of the first sidewall, a side surface of the second convex rib is recessed in a direction of the second convex rib, and a second limiting groove is formed between the side surface of the second convex rib and the first sidewall;
the second sidewall is further provided with a second groove, and a sidewall of the second groove is provided with a second engagement part; and
the overmolded part is formed on the frame body, the second convex rib is located in the second groove, and the second engagement part is located in the second limiting groove, and is engaged with the second limiting groove in the direction perpendicular to the first sidewall.

7. The housing according to claim 6, wherein the retention groove is located between the first convex rib and the second convex rib that are adjacent to each other.

8. The housing according to claim 6, wherein the retention groove is located between the first convex rib and the second convex rib, and a bottom wall of the retention groove is flush with the first sidewall.

9. The housing according to any one of claims 1 to 5, wherein the frame body further comprises a middle plate, the middle plate is disposed side by side with the first mounting frame, and is fixedly connected to one side of the first mounting frame, the overmolded part further comprises a border frame, the border frame is fixedly connected to the second mounting frame, and the border frame covers an outer edge of the middle plate.

10. The housing according to any one of claims 1 to 5, wherein the first sidewall is further provided with an engagement groove, the second mounting frame is further provided with an engagement protrusion, the engagement protrusion is fixedly connected to the second sidewall, and the engagement protrusion is formed in the engagement groove, and is engaged with the engagement groove.

11. The housing according to claim 1, wherein a material of the frame body is metal, and a material of the overmolded part is plastic.

12. An electronic device, comprising a rear cover, a display screen, and the housing according to any one of claims 1 to 11, wherein both the rear cover and the display screen are mounted on the housing.

13. The electronic device according to claim 12, wherein the second mounting frame comprises an accommodation groove, there are two housings, the two housings are disposed side by side, and accommodation grooves of the two housings are opposite to each other and communicate with each other; and
the electronic device further comprises a rotating shaft, the rotating shaft is mounted in the accommodation groove, and is fixedly connected to the two housings, and rotation of the rotating shaft is capable of driving the two housings to rotate relative to each other.
